# EUROPEAN PATENT APPLICATION

(11) **EP 4 199 276 A1**
(43) Date of publication of application: **21.06.2023**
(21) Application number: 21214500.7
(22) Date of filing: 14.12.2021
(51) Int. Cl.: H01S 5/02315, H01S 5/02326, H01S 5/024, H01S 5/04, H01S 5/14, H01S 5/02255, H01S 5/02208, H01S 5/183

(54) **OPTICALLY PUMPED SEMICONDUCTOR LASER ARRANGEMENT**

(71) Applicant: Twenty-One Semiconductors GmbH, 72654 Neckartenzlingen (DE)
(72) Inventor: WITZ, Norbert, 72654 Neckartenzlingen (DE); DR. BEK, Roman, 72654 Neckartenzlingen (DE)
(74) Representative: Weilnau, Carsten

(57) **Abstract**

The present disclosure relates to an optically pumped semiconductor laser arrangement (10), comprising a laser gain unit (100) and an optical pump unit (200), the laser gain unit (100) comprising:
- a planar-shaped semiconductor lasing medium (110) operable for vertical surface emission of a laser radiation (114),
- an emitting surface (140) for emission of the laser radiation (114),
- a first heat spreader (120) thermally coupled to the planar-shaped semiconductor lasing medium (110),
- a backside surface (144) opposite to the emitting surface (140),
the optical pump unit (200) comprising:
- a base substrate (210) comprising a bottom surface (212),
- an optical pump source (220) operable to generate an optical pump radiation (224) and arranged on the base substrate (210), and
- a spacer (230) connected to the base substrate (210) or integrated into the base substrate (210),
- wherein the optical pump unit (200) is mechanically attached to the laser gain unit (100) through a mechanical fastening to the backside surface (144) of the laser gain unit (100).

## Description

### Field of the invention

The present invention relates to the field of semiconductor lasers, in particular to optically pumped semiconductor lasers, such as surface emitting semiconductor lasers with vertical cavities.

### Background

Optically pumped semiconductor lasers, e.g. implemented as vertically emitting semiconductor lasers are well-known in the art. One example of an optically pumped external-cavity surface emitting semiconductor laser, is e.g. described in US 8 170 073 B2.

Generally, surface emitting semiconductor lasers with vertical cavities provide high output power and excellent beam properties over a wide range of wavelengths. In addition, the provision of an external resonator arranged externally to the semiconducting layer structure enables the operation of the semiconductor laser to be influenced by optical elements in order to achieve, for example, a narrow linewidth, a tunable emission wavelength, efficient frequency conversion and/or the emission of ultrashort pulses of laser light.

However, depending on the wavelength of emission of the laser light and thus also on the material system of the amplifier medium in the semiconductor laser, the implementation of this laser concept is currently only possible with a great deal of technical and financial effort.

Currently large pump sources need to be used, and expensive individual heat spreaders need to be installed to dissipate thermal energy generated within the semiconductor laser. The thermal contact between the semiconductor amplifier medium and the heat spreader is poor in the prior art semiconductor laser.

One reason for this substantial technical effort is the lack of availability of cheap pump sources for the semiconductor laser. The pump sources require good beam quality over a wide range of wavelengths and so expensive pump optics need be used to focus the pump beam from the pump laser to a pump spot in the semiconductor laser. However, the combination of the size of a focusing lens in the pump optics and a required minimum distance from the focusing lens to the pump spot is limited geometrically by the 90° angle between the amplifier medium in the semiconductor laser and the generated laser beam in the resonator.

When making use of e.g. one or several edge-emitting laser diodes as a pump for optically pumping the semiconductor laser the pump light source exhibits a rather oval beam profile at an exit face or facet of the respective pump laser diode. As the beam of the pump light source propagates, a rather elliptic beam profile with a long axis in a first transverse direction changes into a rather circular symmetric profile, and as the beam propagates further, changes into an elliptic beam profile with different long-axis along another transverse direction, e.g. perpendicular to the first transverse direction.

For an effective pumping of the laser arrangement it is crucial to provide a precise positioning and/or alignment of an optical pump source with respect to a semiconductor lasing medium or gain medium.

It is therefore an object of the present disclosure to provide an improved optically pumped semiconductor laser arrangement, wherein the optical pump source is easily and precisely arrangeable or can be easily and precisely aligned with regards or relative to the semiconductor lasing medium. Furthermore, it is an aim to provide a scalable solution for a mutual arrangement of an optical pump source and a semiconductor lasing medium of an optically pumped semiconductor laser arrangement.

In one aspect there is provided an optically pumped semiconductor laser arrangement according to the features of the independent claim. Numerous embodiments and examples of the semiconductor laser arrangement are subject of dependent claims.

Accordingly, there is provided an optically pumped semiconductor laser arrangement. The semiconductor laser arrangement comprises a laser gain unit and an optical pump unit. The laser gain unit comprises a planar-shaped semiconductor lasing medium. The lasing medium is operable for vertical surface emission of a laser radiation, e.g. when appropriately pumped by an optical pump radiation, which is e.g. provided by an optical pump source. The laser gain unit further comprises an emitting surface for emission of the laser radiation. The laser gain unit further comprises a first heat spreader. The first heat spreader is thermally coupled to the planar-shaped semiconductor lasing medium.

The laser gain unit further comprises a backside surface that is located opposite to the emitting surface. Typically, the backside surface faces away the emitting surface. The emitting surface faces away the backside surface. With some examples the emitting surface is or forms a front or top surface and the backside surface is or forms a back or bottom surface.

Typically, the first heat spreader is also mechanically coupled, e.g. directly mechanically attached or fixed to the planar-shaped semiconductor lasing medium.

The optical pump unit comprises a base substrate comprising a bottom surface. The optical pump unit further comprises an optical pump source. The optical pump source is operable to generate an optical pump radiation. The optical pump source is arranged on the base substrate. It may be arranged and/or attached directly on the bottom surface of the base substrate.

The optical pump unit further comprises a spacer. The spacer is connected to the base substrate or is integrated into the base substrate. The optical pump unit is mechanically attached or is mechanically attachable to the laser gain unit through a mechanical fastening to the backside surface of the laser gain unit.

Hence, the laser gain unit is mechanically connected and/or mechanically fixed to the optical pump unit via the backside surface. This way, there can be provided a rather direct and well-defined mutual assembly and arrangement of the optical pump unit and the laser gain unit. By way of directly connecting the base substrate and the laser gain unit a separate mount, e.g. providing a common mount for both, the laser gain unit and the optical pump unit, becomes effectively superfluous.

The optical pump source may be directly or indirectly arranged on the base substrate, e.g. on the bottom surface of the base substrate facing the backside surface of the laser gain unit. The spacer is typically provided on the same side of the base substrate, i.e. on that side of the base substrate that faces towards the laser gain unit. The mechanical attachment between the optical pump unit and the laser gain unit might be provided by at least one of the base substrate itself, the optical pump source attached or fixed to the base substrate and the spacer connected or fixed to the base substrate or integrated into the base substrate.

This way, a rather direct mechanical fastening can be provided between the optical pump source and the planar-shaped semiconductor lasing medium. This type of mechanical fixing for the optical pump source relative to the planar-shaped semiconductor lasing medium enables a rather precise and easily reproducible mechanical fixing in the production or manufacturing of the optically pumped semiconductor lasing arrangement.

With some examples the backside surface is part of the first heat spreader. Hence, the heat spreader may form the backside surface or may contribute to the backside surface. Then, mechanical fastening of the optical pump units to the laser gain unit is provided through a mechanical fastening to the first heat spreader. Then, the heat spreader itself not only provides dissipation of thermal energy from the planar-shaped semiconductor lasing medium. The first heat spreader may then also provide a mechanical mount or fastener for mutually fastening and/or fixing the laser gain unit and the optical pump unit.

With some examples there may be provided a kind of a surface mount between the optical pump unit and the backside surface. Hence, the optical pump unit might be exclusively or only attached and/or fixed to the laser gain unit through a mechanical connection to a single surface of the backside surface facing towards the optical pump unit. Mechanical fixing between the laser gain unit and the optical pump unit might be provided by a bonding or by a soldering process.

Here, a surface of the backside surface may be bonded or soldered to a complementary shaped surface of the optical pump unit, e.g. a surface of at least one of the base substrate, the optical pump source and the spacer.

With some examples at least one of the laser gain unit and the optical pump unit can be provided on a wafer scale. Hence, there may be provided a first wafer comprising a number of individual laser gain units and/or there may be provided a second wafer comprising several optical pump units. The laser gain units may be regularly arranged on the first wafer.

The optical pump units may be regularly arranged on the second wafer. The first wafer and the second wafer may be connected or fixed to each other, thereby attaching and/or fixing the laser gain unit to the optical pump unit; and vice versa. After a mutual fixing of the first wafer and the second wafer the wafer assembly provided by the first and second wafers may be cut and/or separated into individual optically pumped semiconductor laser chips. Each laser chip comprises an individual laser gain unit connected and/or fixed to an individual optical pump unit.

This way the present disclosure enables and provides a wafer scale manufacturing and/or production of such optically pumped semiconductor lasers, in particular of semiconductor laser chips.

According to a further example at least one of the spacer and the optical pump source are mechanically fastened, e.g. fixed to the backside surface, e.g. provided on a bottom face of the first heat spreader. With some examples both, the spacer and the optical pump source are mechanically fastened, e.g. fixed to the backside surface. The spacer and/or the optical pump source may comprise a connector surface. The connector surface may be planar shaped and may extend parallel to an outside surface of the backside surface. Insofar, the backside surface may comprise or form a connector surface or connection interface that faces towards the optical pump unit. The connector surface of the backside surface may be, at least in sections, also planar-shaped and may form a surface connection with the connection surface of at least one of the spacer and the optical pump source.

With some examples the backside surface comprises the connection surface on a side that faces away the emission side or emitting surface of the planar-shaped semiconductor lasing medium. The laser gain unit is typically implemented as a vertical surface emitter. Hence, the laser radiation emitted by the planar-shaped semiconductor lasing medium propagates along a surface normal of the planar-shaped semiconductor lasing medium. With some examples the planar-shaped semiconductor lasing medium is operable to emit the laser radiation towards an upper side, e.g. towards the emitting surface. Here, the backside surface is provided at an oppositely located lower side of the laser gain unit.

With further examples the first heat spreader may provide a substrate onto which the planar-shaped semiconductor lasing medium is arranged or provided.

According to further examples the laser arrangement comprises a submount. The submount comprises a first side mechanically connected to the optical pump source. The submount further comprises a second side opposite to the first side. The second side is mechanically connected to one of the bottom surface of the base substrate and the first heat spreader.

Hence, with some examples the optical pump source may be directly arranged and/or attached on the bottom surface of the base substrate. Then, the submount is located between the optical pump source and the first heat spreader. The submount may provide a kind of a spacer in order to fill a gap between a side of the optical pump source facing away the bottom surface of the base substrate and the backside surface.

With other examples the submount is directly connected or fixed on the bottom surface of the base substrate. Then, the optical pump source is attached on a side or surface of the submount that faces away the bottom surface of the base substrate. With this example, a side of the optical pump source facing away the base substrate may get in direct contact, e.g. surface contact with the backside surface.

By way of the submount there can be provided a well-defined distance, i.e. a well-defined optical path length between the optical pump source and the planar-shaped semiconductor lasing medium. In this context, the vertical direction extends along a surface normal of the planar-shaped semiconductor lasing medium, which surface normal extends along or parallel to a surface normal of the backside surface, which may be also of planar shape.

With some examples the spacer and at least one of the submount and the optical pump source are directly connected, fastened or fixed to the backside surface. This way, the mechanical stability of the connection between the optical pump unit and the laser gain unit can be enhanced. Moreover, by making use of the submount, a gap-free arrangement of the optical pump source between the bottom surface and the backside surface can be provided. This way and with the submount there may be even a thermal coupling between the optical pump source and the heat spreader, especially when the backside surface is provided by or integrated into the first heat spreader. This way, the first heat spreader may provide a twofold or double function. It may serve to dissipate thermal energy generated by the planar-shaped semiconductor laser medium and may also provide dissipation of thermal energy generated by the optical pump unit.

According to further examples the optical pump source comprises a pump laser operable or effective to deliver optical energy into the lasing medium effective to create a population inversion in the lasing medium. With further examples the optical pump source comprises an edge-emitting pump laser. The pump laser is typically implemented as a semiconductor laser. The edge-emitting pump laser may be arranged substantially perpendicular to the planar shape of the semiconductor lasing medium and/or of the planar shape of the backside surface or heat spreader. With some examples the edge-emitting pump laser may be arranged parallel to the planar-shaped semiconductor lasing medium. For directing the optical pump radiation into the planar-shaped semiconductor lasing medium there may be provided a deflection or reflection of the optical pump radiation after emission from the edge-emitting pump laser.

According to a further example the optical pump unit comprises a mirror, typically a slanted mirror to deflect or redirect the optical pump radiation as received from the optical pump source towards and into the planar-shaped semiconductor lasing medium. Typically, the spacer comprises or is provided with such a slanted mirror. By way of the slanted mirror and its integration in or on the spacer there can be provided an integrated optical pump unit comprising a horizontally oriented pump source, e.g. arranged on the bottom surface of the base substrate. By way of the slanted mirror or optical deflector the optical pump unit is operable to direct the optical pump radiation in vertical direction, i.e. substantially perpendicular to the plane of the bottom surface and/or perpendicular to the plane of the planar-shaped semiconductor lasing medium.

By way of a deflector or by way of the slanted mirror the optical path length between the optical pump unit and the semiconductor lasing medium of the laser gain unit can be easily modified, namely by varying the position of the optical pump source in the plane of the base substrate or in the plane of the bottom surface of the base substrate.

According to a further example the optical pump source is oriented to emit the optical pump radiation in a horizontal direction towards the slanted mirror. A horizontal distance between the optical pump source and the slanted mirror is adjusted or is adjustable to realize a predetermined optical path length between the optical pump source and the planar-shaped semiconductor lasing medium when the optical pump unit and the laser gain unit are mutually connected and/or fixed to each other.

Typically, and with a horizontal or parallel orientation relative to the bottom surface the optical path length can be varied by modifying the horizontal position of the optical pump unit relative to the mirror. Such a modification of the horizontal position or alignment is much easier to realize compared to a variation along the vertical direction. This is of particular use when at least one of the laser gain unit and the optical pump unit comprises numerous horizontally extending or planar shaped layers.

Variations of a layer thickness are quite difficult to realize. Also, variations in the vertical spacing between the optical pump source and the semiconductor lasing medium are generally difficult to implement. By way of the slanted mirror in combination with a variation or adjustable alignment or positioning of the optical pump source on or in the plane of the base substrate the optical path length between the optical pump source and the semiconductor lasing medium can be precisely adjusted in a rather easy and straightforward manner. The horizontal alignment or horizontal orientation of the optical pump source, by way of which the optical pump radiation propagates initially in horizontal direction, i.e. parallel to the planar-shaped bottom surface of the base substrate, and by redirecting the pump radiation towards a vertical direction, e.g. towards the planar-shaped semiconductor lasing medium a desired beam profile in the region of the semiconductor lasing medium can be easily adjusted.

According to a further example the spacer comprises a crystalline or semicrystalline semiconductor material with a slanted sidewall facing towards the optical pump source. The slanted sidewall may be etched anisotropically along a crystallographic plane of the semiconductor material. With some examples the semiconductor material of the spacer is unitarily formed with the material of the base substrate. Hence, the base substrate and the spacer are integrally formed or constitute a single piece.

Through the anisotropy of an etching rate the slanted sidewall extends at a predetermined angle as defined by the crystallographic structure of the semiconductor material. The sidewall may be formed along a {110} plane or by a {111} plane of the crystallographic structure. This way, the slanted sidewall may extend relative to the bottom surface at an angle of about 45° or at an angle of about 54.74°. The semiconductor material may comprise or may consist of silicon. By way of an anisotropic etching, a highly precise and planar-shaped slanted sidewall can be produced and provided, which is directly suitable for supporting the slanted mirror.

According to a further example at least a portion of the slanted sidewall is coated with a mirror layer. The mirror layer may comprise a highly reflective material, such as a noble metal, e.g. silver or gold.

According to a further example the spacer comprises a stop face to abut with a counter stop face of the optical pump source, which counter stop face may be complementary shaped to the stop face. The stop face typically faces in horizontal direction. In effect, the stop face may extend parallel to a surface normal of the bottom surface. The stop face of the spacer and the counter stop face of the optical pump source may be oriented or arranged substantially parallel to each other. The stop face of the spacer may provide or act as a horizontal stop so as to define a predetermined position of the optical pump source on the base substrate, e.g. on the bottom surface.

With some examples the surface of the spacer may delimit or confine the bottom surface of the base substrate. The stop face of the spacer provides a mechanical stop for mounting the optical pump source on the base substrate. Hence, the stop face may protrude from the bottom surface and may extend along a surface normal of the bottom surface towards the heat spreader. When the counter stop face of the optical pump source gets in direct contact or in direct abutment with the stop face of the spacer a final and predefined assembly configuration has been reached for the optical pump source.

Typically and with further examples the surface of the spacer also delimits or confines a sloped or slanted sidewall of the spacer. Typically, the stop face forms a lower end of the slanted sidewall, which may be provided with the slanted mirror. This way the stop face provided a well-defined reference point or reference surface for mounting and/or arranging the pump source on the base substrate. The stop face may be etched or may be generated by way of ablating. This way, the position and/or shape of the stop face can be provided with high precision, e.g. lithographically.

Typically, the edge-emitting facet of the optical pump source is provided at a well-defined vertical distance from an upper edge or upper end of the stop face. In this way, there can be provided a predefined distance between the pump radiation emitted by the optical pump source and the slanted mirror.

According to a further example at least a portion of at least one of the bottom surface, the spacer and the submount is coated or covered with an electrically conductive layer. With some examples the electrically conductive layer may provide a mechanical fastening between at least one of the spacer and the submount with at least one of the optical pump source and the backside surface and/or first heat spreader of the laser gain unit. With some examples the electrically conductive layer is provided between the bottom surface and at least one of the spacer, the optical pump source and the submount.

It may be provided between the bottom surface and one of the spacer and the submount. It may be provided between the backside surface of the laser gain unit and at least one of the spacer, the submount and the optical pump source.

The electrically conductive layer may be implemented as a soldering layer. Hence, the electrically conductive layer may comprise a solder material by way of which a mechanical fastening can be provided by way of soldering.

Moreover and by way of the electrically conductive layer the optical pump source can be provided with electrical energy for driving the optical pump source. With some examples, the optical pump source comprises a first contact side and a second contact side electrically isolated from each other and each of which connected with a respective electrically conductive structure in order to provide electrical power to the optical pump source.

According to a further example the laser arrangement comprises a first electrical contact path extending through a first through opening of the base substrate or extending on a first lateral extension of the base substrate. The first electrical contact path is further electrically connected to a first contact side of the optical pump source. Here, almost the entirety or at least a major portion of a side surface of the optical pump source may be in direct electrical contact with the first electrical contact path.

The lateral extension of the base substrate may protrude laterally from the spacer. This way, the bottom surface of the base substrate may be accessible from that side of the optical pump unit that faces towards the laser gain unit. This allows and supports a rather easy and straightforward electrical contracting, e.g. from the top or from the side of the laser arrangement.

The electrical contact path may comprise a rather planar-shaped electrical contact or contact path, e.g. extending on the bottom surface of the base substrate. The electrically conductive layer may provide a twofold function. It may provide a mechanical fastening of the optical pump source to the base substrate. It may also provide electrical power to the optical pump source.

According to a further example the laser arrangement comprises a second electrical contact path extending through a second through opening of the base substrate or extending on a second lateral extension of the base substrate. The second electrical contact path further extends through or on the spacer. The second electrical contact path is electrically connected to a second contact side of the of optical pump source. Typically, the first and the second electrical contact paths are electrically isolated from each other. When extending through a first and second through opening of the base substrate they may be provided on a backside of the base substrate and may penetrate through the respective through openings in the substrate onto or towards a front side of the substrate, where the optical pump source is located.

With at least one of a first and a second lateral extension of the base substrate the respective first and/or a second electrical contact paths may be provided on the bottom surface of the base substrate facing towards the laser gain unit. Typically, the first and/or second lateral extensions may protrude laterally from the spacer. They are hence accessible from a top side or from that side of the base substrate that faces towards the laser gain unit. This allows for a rather easy and straightforward electrical contact of the laser arrangement.

According to a further example the second electrical contact path is electrically connected to the second contact side of the optical pump unit via the backside surface, e.g. via a contact surface of the first heat spreader. Here and when the laser gain unit and the optical pump unit are assembled and/or fixed together the second electrical contact path may extend from a backside of the base substrate, through the base substrate and optionally also through or on the spacer towards a connection surface of the spacer, which is in direct surface contact with the backside surface, e.g. with the complementary-shaped connection surface of the first heat spreader.

From there, the second electrical contact path may extend along the connection surface of the first heat spreader, which may be in turn in surface contact with the second contact side of the optical pump source. This arrangement is particularly provided, when the submount of the optical pump unit is located between the optical pump source and the first heat spreader.

With other examples, wherein the optical pump source is provided or located between the bottom surface of the base substrate and the submount, e.g. when the submount is sandwiched between the backside surface and the optical pump source, it may be the submount that comprises at least one or several through openings for an electrically conductive layer, which is then in direct surface contact with the optical pump source, i.e. with the second contact side of the optical pump source.

According to a further example the optical pump unit is mechanically fastened to the backside surface by one of a soldering or bonding. Here, a contact surface of at least one of the spacer, e.g. protruding in vertical direction from the planar-shaped bottom surface of the base substrate is connected to the backside surface of the laser gain unit and/or to a contact surface of the first heat spreader by way of soldering or bonding. The same may apply to a surface of the optical pump unit or to the submount.

According to a further example the laser gain unit comprises a functional optical layer arranged in an optical path of the optical pump radiation. It is typically arranged between the planar-shaped semiconductor lasing medium and the optical pump source. The functional optical layer is substantially reflective for the laser radiation and is substantially transmissive for the optical pump radiation. The functional optical layer may comprise one or several dielectric layers. The functional optical layer may be provided in the optical path of the of optical pump radiation as provided by the optical pump unit.

Typically, the functional optical layer is provided on a lower side of the first heat spreader facing towards the optical pump unit. It may be provided on the backside surface or may form the backside surface. This way a kind of a backside-pumped semiconductor laser arrangement can be provided. Pump radiation emitted and provided by the optical pump source may enter the laser gain unit via the functional optical layer. Stimulated emission induced by the optical pump radiation in the planar-shaped semiconductor lasing medium may then reflect at the functional optical layer, so that the functional optical layer also forms a mirror of the surface emitting vertical laser cavity.

With some examples the functional layer, e.g. the dielectric layer may be provided at the backside surface of the laser gain unit. It may form or constitute the backside surface of the laser gain unit. Then, the optical pump unit may be mechanically attached to the laser gain unit through a mechanical fastening to the functional layer, e.g. forming a bottom side of the laser gain unit.

According to a further example the laser gain unit comprises an emitting surface facing away the optical pump unit. This way, a backside pumped semiconductor laser arrangement can be provided, which might be equipped with an external cavity mirror. The external cavity mirror may be provided at a vertical distance from the emitting surface of the laser gain unit. The functional optical layer may provide a first mirror of the laser cavity and the external mirror may provide a second, hence the other mirror of the laser cavity.

According to a further example at least a portion of the surface of the planar-shaped semiconductor lasing medium and/or of the heat spreader is provided with an anti-reflex coating. By way of an anti-reflex coating, intracavity reflections can be suppressed in order to avoid a sub-cavity effect or etalon effect in the laser cavity.

Typically, the active or lasing medium is selected from the group of semiconducting materials comprising or consisting of: AIGalnAsP (including AIGaAs, InGaAs and AIGalnP), AllnGaN, or AIGalnAsSb or AIGalnNAs, but this is not limiting of the invention.

Furthermore, with some examples the material used in the optical functional layers, the mirror layer or dielectric layer(s) can be selected from the at least one or several of the following materials or material combinations: SiO₂, Nb₂O₅, HfO₂, TiO₂, Al₂O₃, Ta₂O₅, AlGaAs, InAlGaAs, AlGaSb, Si, and Ge.

Generally, and with the currently proposed arrangement and mutual fixing of the laser gain unit and the optical pump unit the lasing medium can be appropriately pumped directly by the optical pump source without use and hence by omission of any beam shaping optical components.

Typically, the lasing medium comprises numerous layers of different semiconducting materials or material combinations. The heat spreader may comprise a planar shaped single-crystalline material which exhibits a well-defined thermal conductivity and provides dissipation of thermal energy generated or released in the lasing medium. Typically, also the functional optical layer comprises numerous individual layers of different materials by way of which a functional optical layer structure is provided featuring a well-defined and predetermined degree of optical reflectivity, in particular for the laser wavelength. With some examples the first heat spreader and/or an optional second heat spreader is selected from the group of thermally conductive materials comprising silicon carbide, diamond, or aluminum oxide.

It should be noted that, as far as technically feasible or possible, any features, structures or effects described herein in connection with only one example or embodiment equally apply also to any other example or embodiment as disclosed herein.

### Brief Description of the Drawings

In the following, numerous examples and embodiments of a semiconductor lasing arrangement will be described in greater detail by making reference to the drawings, in which:
- Fig. 1: schematically illustrates a first example of an optically pumped semiconductor laser arrangement,
- Fig. 2: shows another example of such a laser arrangement,
- Fig. 3: is a three-dimensional illustration of another example of a laser arrangement,
- Fig. 4: is a top view of the laser arrangement according to Fig. 3,
- Fig. 5: is a longitudinal cross-section through the laser arrangement according to Figs. 3 and 4,
- Fig. 6: is a transverse cross-section through the laser arrangement according to Figs. 3-5,
- Fig. 7: shows another example of an optically pumped semiconductor laser arrangement,
- Fig. 8: shows a further example of the laser arrangement,
- Fig. 9: shows a further example of the laser arrangement,
- Fig. 10: shows a further example of the laser arrangement,
- Fig. 11: shows another example of a laser arrangement,
- Fig. 12: shows another example of the semiconductor laser arrangement,
- Fig. 13: shows another example of an optically pumped semiconductor laser arrangement,
- Fig. 14: shows a further example an optically pumped semiconductor laser arrangement.

### Detailed description

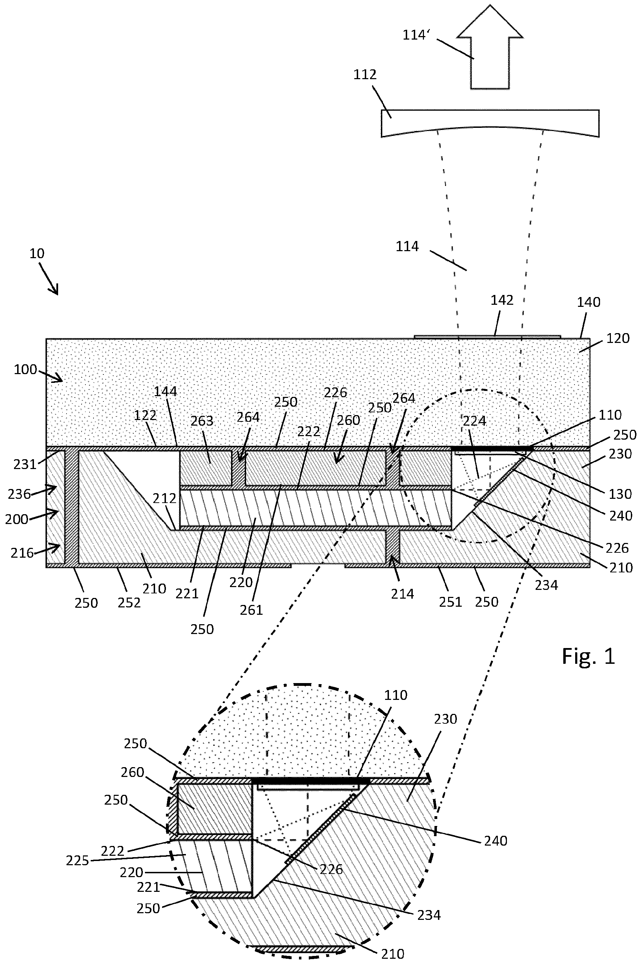

In Figs. 1-13 there are illustrated numerous examples of optically pumped semiconductor laser arrangements 10. The laser arrangement 10 comprises a laser gain unit 100 and an optical pump unit 200. The laser gain unit 100 comprises a planar-shaped semiconductor lasing medium 110. The lasing medium, also denoted as a laser membrane or gain medium, is operable to emit a laser radiation 114 in vertical direction, i.e. perpendicular to a planar-shaped emitting surface 140, when optically pumped. Hence, the laser gain unit 100 may provide or constitute a surface emitting semiconductor laser with a vertical cavity. The laser gain unit 100 not only comprises the lasing medium 110 but also at least a first heat spreader 120 thermally coupled to the lasing medium 110. By way of the heat spreader 120 thermal energy generated in the region of the lasing medium 110 can be dissipated in a controlled manner. Moreover, the laser medium can be effectively cooled by the first heat spreader 120. The laser gain unit 100 comprises the emitting surface 140 forming or constituting an upper surface. The laser gain unit 100 further comprises a backside surface 144 opposite to the emitting surface 140. The backside surface 144 forms or constitutes a bottom surface. The backside surface 144 and the emitting surface 140 are both of planar shape. They extend substantially parallel to each other.

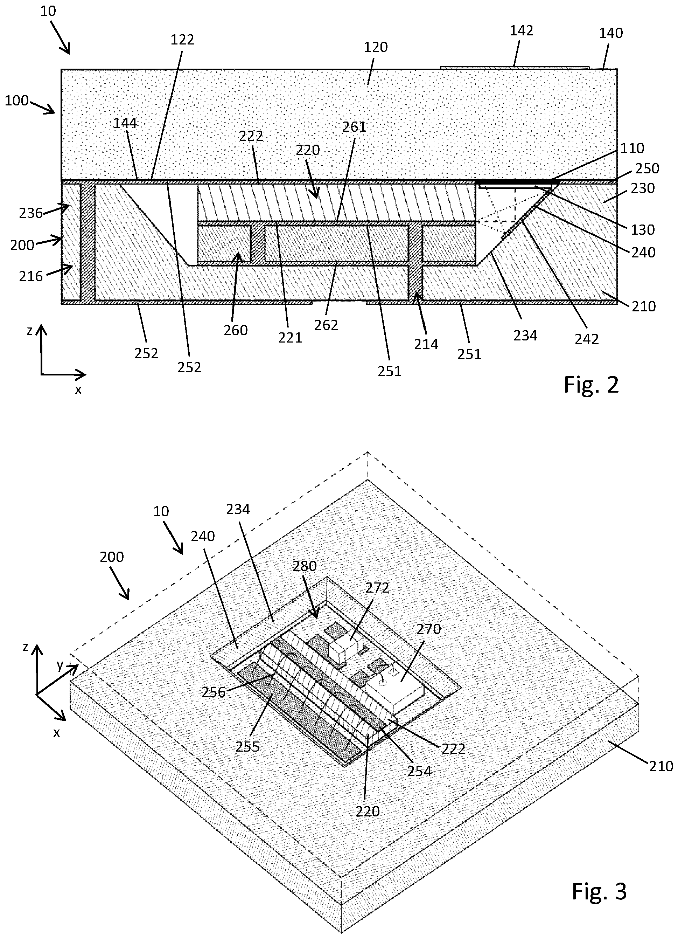

The semiconductor laser arrangement 10 further comprises an optical pump unit 200. The optical pump unit 200 comprises a base substrate 210 featuring a bottom surface 212. The optical pump unit 200 further comprises an optical pump source 220, which is operable to generate an optical pump radiation 224. The optical pump source 220 is arranged on the base substrate 210. It may be either directly arranged on the bottom surface 212 as illustrated in Fig. 1. With other examples, e.g. with the example of Fig. 2 the optical pump source 220 is indirectly arranged on the base substrate 210. There, a submount 260 is arranged on the base substrate 210 and the optical pump source 220 is arranged on the submount 260. Hence, the submount 260 is sandwiched between the base substrate 210 and the optical pump source 220.

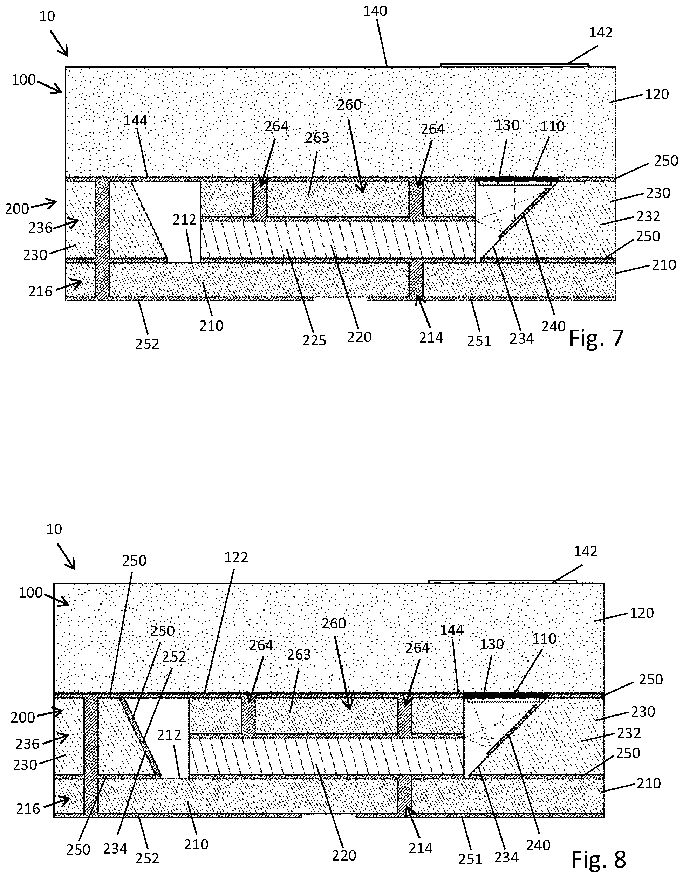

The laser arrangement 10, in particular the optical pump unit 200, further comprises at least one spacer 230. The spacer 230 is connected to the base substrate 210. It may be provided as a separate piece as illustrated with the example of Figs. 7-10, 12 and 13. With other examples the spacer 230 is integrally formed with the base substrate 210.

The optical pump unit 200 is mechanically attached to the laser gain unit 100 through a mechanical fastening to the backside surface 144. With the example of Fig. 1, the backside surface 144 is constituted or formed by the first heat spreader 120. Hence, a bottom surface of the first heat spreader 120 coincides with the backside surface 144 of the laser gain unit 100. With other examples the backside surface 144 may be provided by any other layer or material that forms a bottom surface of the laser gain unit 100. With some examples, such a backside surface 144 may be formed or constituted by a functional optical layer 130 as will be described in greater detail below. Then, the functional optical layer 130 may provide the backside surface 144 by way of which the laser gain unit 100 is mechanically fixed to the optical pump unit 200.

The first heat spreader 120 comprises a contact surface 122 serving as a connection surface or connection interface. In the illustration of Fig. 1 the backside surface 144, and hence the contact surface 122 is a lower surface. It is located opposite to the emitting surface 140. Hence, the contact surface 122 of the first heat spreader 120 forms a bottom side of the first heat spreader 120 whereas the emitting surface 140 is a top side of the heat spreader 120. Irrespective of an orientation of the laser arrangement 10, the contact surface 122 or backside surface 144 is located opposite the emitting surface 140.

The optical pump source 220 may comprise an edge-emitting pump laser 225. As shown in the enlarged illustration of Fig. 1 the edge-emitting pump laser 225 is operable to emit the optical pump radiation 224 at or near an upper end of the side edge of the optical pump source 220. Hence, an edge-emitting facet 226 is located at a predetermined vertical distance from the bottom surface 212 of the base substrate 210. With the example of Fig. 1 the optical pump source 220 is directly mounted or attached on the bottom surface 212. As further illustrated in Fig. 1, the bottom surface 212 is confined in horizontal direction by a slanted sidewall 234. The sidewall 234, at least a section thereof is provided with a mirror 240. The mirror 240 is arranged at a vertical position opposite to the position of the edge-emitting facet 226 of the edge-emitting pump laser 225. The sidewall 234 may be provided by and/or on the spacer 230.

This way, almost the entirety of the pump radiation 224 emitted by the edge-emitting pump laser can be redirected by the mirror 240, substantially in vertical direction and hence towards the lasing medium 110.

With the present example the lasing medium 110, hence the laser membrane 110 is arranged at or on the contact surface 122 of the heat spreader 120. In order to establish a vertical cavity for the laser gain unit 100 there is also provided a functional optical layer 130 on that side of the lasing medium 110 that faces away the heat spreader 120. The functional optical layer may comprise a dielectric layer or several dielectric layers, semiconductor layers or combinations thereof. Hence, optical pump radiation 224 as generated by the optical pump source 220 initially propagates in horizontal direction and hence substantially parallel to the plane of the bottom surface 212 of the base substrate 210. By way of the mirror 240 the pump radiation 224 is deflected in vertical direction, e.g. upwardly. It propagates through the functional optical layer 130, which is effectively transparent and hence highly transmissive for the optical pump radiation 224. The pump radiation 224 entering the lasing medium 110 creates population inversion in the lasing medium 110 effective to create emission of the laser radiation 114. Since the functional optical layer 130 is highly reflective for the laser radiation 114 the functional optical layer 130 also serves as a mirror of the laser cavity.

Typically, the base substrate 210 and with some examples also the spacer 230 is or are made from a semiconductor material, e.g. from a crystalline or semicrystalline semiconductor material, such as silicon. By way of an isotropic etching of the crystalline or semicrystalline material there can be provided a rather well-defined slanted sidewall 234 of the spacer 230. Accordingly and when appropriately etched along a crystallographic axis an angle of 45° or 54.74° between the surface of the sidewall 234 and the bottom surface 112 may be provided. This way, there can be provided rather precise and planar-shaped angled or slanted sidewall 234, which is suitable for mounting the mirror 240. Hence, the mirror 240 may be coated on the anisotropically etched sidewall 234 of the spacer 230. Insofar the mirror 240 may comprise a mirror layer 242 coated or arranged on the slanted sidewall 234.

An external mirror 112 located at a predefined distance from the emitting surface is highly reflective or partially reflective for the laser radiation 114. In this way, a (vertical) laser cavity can be provided between the external mirror 112 and the functional optical layer 130. The edge-emitting pump laser 225 provides a rather elliptic beam profile and comprises a fast axis and a slow axis. Hence, as the pump radiation 224 propagates the divergence of the pump beam differs with regards to the two transverse directions.

For a rather efficient pumping of the lasing medium it would be beneficial to have a somewhat circular and/or homogeneous beam profile of the optical pump radiation 224 in the region of the lasing medium 110. This can be achieved by adjusting the optical path length between the optical pump source 220 and the semiconductor lasing medium 110. By way of the mirror 240 an optical path length between the optical pump source 220 and the lasing medium 110 can be adjusted by appropriate moving or arranging the optical pump source 220 in horizontal direction, i.e. in the plane of the bottom surface 212 (x, y) relative to the mirror 240.

Hence, for modifying the optical path length or for obtaining or realizing a predefined optical path length it will only be necessary to properly arrange the optical pump source 220 with regards to its horizontal position in the plane of the bottom surface 212. Otherwise, there would be required modification of a vertical distance spacing (z) between the laser gain unit 100 and the optical pump unit 200, which would be difficult to realize, especially for a mass manufacturing of the semiconductor laser arrangement 10.

By way of a horizontally emitting pump source 220 in combination with a mirror 240 there can be provided a rather efficient and precise optical path length adjustment, which is particularly suitable for a mass manufacturing of semiconductor laser arrangements 10.

The emitting surface 140 of the heat spreader 120 is provided with an anti-reflex coating 142. By way of the anti-reflex coating 142 sub-cavity effects or etalon effects in the laser resonator can be avoided.

Both, the laser gain unit 100 as well as the optical pump unit 200 can be manufactured individually, hence, the heat spreader 120 as such and/or the lasing medium 110 and/or the base substrate 210 can be manufactured by epitaxial growth and/or by vapor deposition techniques. This allows a mass manufacturing of numerous semiconductor laser arrangements on a wafer scale. Hence, the presently illustrated laser arrangement may be a laser chip which is cut from a mutual fixing or bonding of a first wafer comprising numerous laser gain units and a second wafer comprising numerous optical pump units. This way, production and manufacturing costs for the presently illustrated optically pumped semiconductor laser arrangement 10 can be reduced.

As illustrated in Fig. 1 the optical pump source 220 is directly arranged on the bottom surface 212 of the base substrate 210. There is further provided an electrically conductive layer or conductive structure 250 between the optical pump source 220 and the bottom surface 212. The conductive structure 250 may provide a twofold function. By way of conductive structure 250 there can be provided an electrical contact for the optical pump source 220. At the same time the optical pump source 220 can be mechanically fixed to the bottom surface 212 by or via the conductive structure 250.

With the present example there is provided a first electrical contact path 251 extending from a backside of the base substrate 210 through a first through opening 214 in the base substrate 210 towards the bottom surface 212, which bottom surface 212 faces towards the contact surface 122 of the heat spreader 120. As illustrated in Fig. 1 the entirety of a first contact side 221 of the optical pump source 220 may be in electrical and/or mechanical contact with the first electrical contact path 251.

There is also provided a second electrical contact path 252 electrically isolated from the first electrical contact path 251. The second electrical contact path 252 also extends from a backside of the base substrate 210 through a second through opening 216 of the base substrate 210. With the present example the first electrical contact path 251 and/or second electrical contact path 252 comprises an electrically conductive material, such as copper or gold.

The second electrical contact path 252 extends through the spacer 230 towards and onto an upward facing contact face 231 of the spacer 230. There, the second electrical contact path 252 extends on or along the contact surface 122 of the heat spreader 120 and is further configured to make electrical contact with a second contact side 222 of the optical pump source 220.

As further illustrated in Fig. 1 there is provided a submount 260 between an outside facing surface of the optical pump source 220 and the contact surface 122 of the first heat spreader 120. The mount 260 may fill a gap between the lower side or contact side 122 of the heat spreader 120 and an upper side of the optical pump source 220. Such a submount 260 or spacer is beneficial to establish and/or to provide a predefined optical path length between the optical pump source 220 and the lasing medium 110.

The submount 260 may comprise one or numerous through recesses or through openings that provide a respective guiding of the second electrical contact path 252. Here, a respective conductive structure made of conductive material may extend through the respective openings of the submount 260 and may form an electrical contact with the second contact side 222 of the optical pump source 220. This way, there can be provided an effective electrical contact for the optical pump source 220.

Both electrically separated electrical contacts, hence the first electrical contact path 251 and the second electrical contact path 252 can be provided on a backside of the base substrate 210, which is e.g. accessible from outside the semiconductor laser arrangement 10. In this way a rather compact and elegant approach is provided to make electrical contact for the optical pump source 220.

The material of the submount 260 and the material of the base substrate 210 and/or of the spacer 230 can be the same or can be different. With some examples the base substrate 210 comprises at least one or a combination of a semiconductor material, e.g. silicon and a ceramic material, such as AlN, BeO₂. The spacer 230 typically comprises crystalline silicon. With the example of Fig. 1 a first side 261 of the submount 260 is connected to the optical pump source 220. A second side 262 of the submount 260 is mechanically connected to the backside surface 144, e.g. to the heat spreader 120.

With an alternative solution as illustrated in Fig. 2 the first side 261 of the submount 260 is connected to the optical pump source 220 and the second side 262 of the submount 260 is connected to the base substrate 210. There, the optical pump source 220 is directly connected to the contact surface 122 of the heat spreader 120.

Here and in contrast to the illustration of Fig. 1 the facet 226 of the edge-emitting pump laser 225 is located at a predefined distance from the contact surface 122 in order to obtain or to realize a predefined optical path length between the optical pump source 220 and the lasing medium 110.

By having numerous through openings 264 extending through a layer 263 or material of the submount 260 a rather homogeneous current distribution can be provided across or along the conductive structure 251, e.g. extending all along the second contact side 222 of the optical pump source 220.

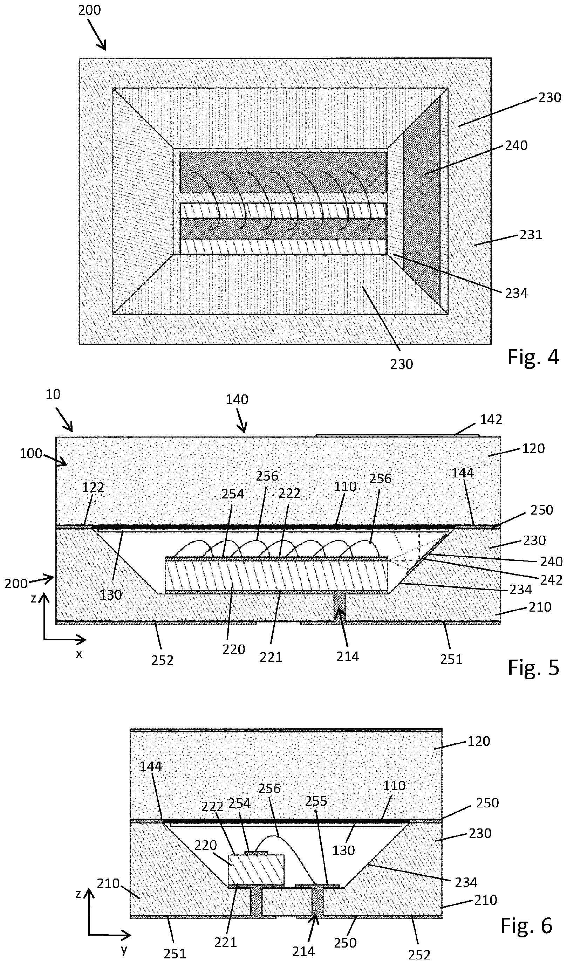

With the further example as illustrated in Figs. 3-6 the electrical contact of the second contact side 222 of the optical pump source 220 is provided by a number of wire bonds 256. There and as illustrated in Fig. 6 the first electrical contact path 251 extends through a first through opening 214 of the base substrate 210. Hence, the electrically conductive structure 250 extends through the first through opening 214 and forms a planar, e.g. straight and elongated conductor being in electrical contact with the first contact side 221 of the optical pump source 220.

The oppositely located second contact side 222 is provided with a separate elongated conductor 254. This conductor 254 is in electrical contact with another conductor 255 provided on the upper side of the base substrate 210. This electrical conductor 255 contributes or belongs to the second electrical contact path 252. The respective conductive structure 250 extends through a second through opening 216 of the base substrate 210. The conductor 255 and the conductor 254 extend substantially parallel to each other and are connected by a plurality of wire bonds 256.

In comparison to the electrical contact arrangement of the optical pump source 220 there can be provided a likewise electrical contact. As further illustrated in Fig. 3, the optical pump unit 200 comprises a depression 280 and/or a recessed portion entirely surrounded by the spacer 230. Hence, the spacer 230 forms or establishes a circumferential enclosure for the optical pump source 220. The depression 280 provides construction space for the optical pump source 220. Optionally, there may be also provided an optical power control 270 to regulate and/or to control operation of the optical pump source 220. In addition, there may be provided an electronic temperature control 272. The temperature control 272 as well as the power control 270 may be located next to the elongated optical pump source 220.

With the examples of Figs. 3-6 there is provided a conductive structure 250 between the spacer 230 of the optical pump unit 200 and the backside surface 144 of the laser gain unit 100. Here, the conductive structure 250 may not have a particular electrically conductive function. It may comprise a solder by way of which there can be provided a mutual mechanical fastening between the laser gain unit 100 and the optical pump unit 200.

With other examples (not illustrated) it is also possible that the interface between the heat spreader 120 and the spacer 230 is provided with at least one of the lasing medium 110 and the functional optical layer 130. Then, a respective surface of the lasing medium 110 and the functional optical layer 130 provides or constitutes the backside surface 144 by way of which the optical pump unit 200 is mechanically fastened to the laser gain unit 100.

With some examples the submount 260 is manufactured from isolating ceramic materials comprising numerous through recesses or through openings 264. Examples of suitable materials are AlN, BeO₂, CuW or metal-ceramic-hybrid materials, such as Cu-AlN-Cu. Here, it is of particular benefit, when the material of the submount has a coefficient of thermal expansion (CTE) in the same region or magnitude than the CTE of the material of the optical pump source 220.

Even though the numerous illustrations of the laser arrangement 10 show an electrical contact for the optical pump source 220 via the first and second electrical contact path 251, 252 accessible from the backside of the base substrate 210 it is also possible to implement an electrical contact via a lateral outside facing side, e.g. of the spacer 230. This would allow to make electrical contact with the optically pumped semiconductor laser arrangement 10 from above.

Typically, and with some examples it is beneficial to implement at least a portion of the conductive structure 250 as a hard solder or soft solder. With the example of Fig. 1 it is beneficial to provide a hard solder between the submount 260 and the optical pump source 220. An indirect mechanical or electrical contact of a hard solder with the p-n junction of the edge-emitting pump laser 225 may prolong or extend the lifetime of the optical pump source 220. Other portions of first and second electrical contacts 251, 252, e.g. in the region between the optical pump source 220 and the base substrate 210 with the example of Fig. 1 as well as in the region between the spacer 230 and the heat spreader 120 may comprise a soft solder. Use of a soft solder enables a tolerance compensation when mounting or assembling the individual components of the laser arrangement 10.

With the example of Fig. 7 the spacer 230 and the base substrate 210 of the optical pump unit 200 are made of different materials. Moreover, the spacer 230 and the base substrate 210 are provided as separate pieces being mutually assembled and/or fixed together. Here, the base substrate 210 may comprise a ceramic material. The spacer 230 typically comprises a semiconductor material 232. The spacer 230 and the base substrate 210 may be mutually connected by way of soldering or bonding. Here, the electrically conductive structure 251, hence a layer of an electrically conductive material may comprise a solder. Typically, the coefficient of thermal expansion (CTE) of the base substrate 210 closely matches the CTE of the semiconductor material 232 of the spacer 230 and/or of the semiconductor material of the semiconductor pump laser 225.

With the further example of Fig. 8 the second electrical contact path 252 comprises an electrically conductive structure 250 extending on the surface of the sidewall 234 of the spacer. Here, the second electrical contact path 252 extends through a through opening 236 extending vertically through the spacer 230. With the example of Fig. 8 such a through extension through the spacer 230 is no longer required. Rather, the planar-shaped bottom surface 212 of the base substrate 210 is provided with a layer of the conductive structure 250, which is further connected with a respective layer 250 of conductive material extending along the sidewall 234.

The conductive structure 250 extends from a bottom edge of the sidewall 234 towards an upper edge of the sidewall 234. This way, the sidewall 234, and in particular the conductive structure 250 as provided on the sidewall 234 provides an electrical contact between the conductive structure 250 provided on the bottom surface 212 and the conductive structure 250 provided on the contact surface 122 of the first heat spreader 120. With this solution a through opening 236 through the spacer 230 is no longer required.

With the solution according to Fig. 8 and by providing an electrically conductive structure 250 on the side wall 234 a rather easy and straightforward electrical connection can be provided between the base substrate 210 and the contact surface 122 of the heat spreader 120.

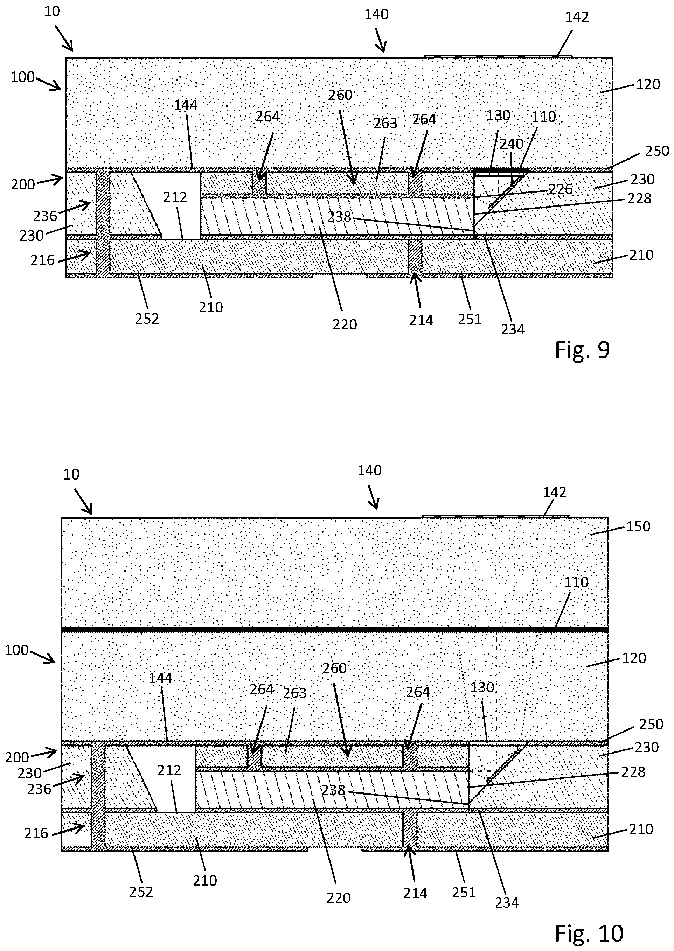

With the further example as e.g. illustrated in Figs. 9, 10 and 12 the spacer 230 further comprises a stop face 238 facing towards the optical pump source 220. The optical pump source 220 comprises a counter stop face 228, which might be complementary shaped to the shape of the stop face 238 of the spacer. This way and when the stop face 238 engages, e.g. abuts the counter stop face 228, a well-defined horizontal distance between the edge-emitting facet 226 of the optical pump source 220 and the mirror 240 can be provided. Modifying the horizontal position, i.e. the position of the optical pump source 220 in the plane of the bottom surface 212, e.g in a x-y-plane, is typically much easier than modifying a vertical positioning of the optical pump source 220 relative to the base substrate 210, i.e. along the vertical axis z.

By way of the mechanical stop faces 228, 238, alignment and fastening of the optical pump source 220 on the base substrate 210 can be facilitated. Moreover, the precision of alignment of the optical pump source 220 relative to the mirror 240 and hence also relative to the lasing medium 110 can be improved.

With the example of Fig. 10 there is provided a second heat spreader 150. There, the lasing medium 110 is located on a side of the first heat spreader 120 that faces away a contact surface 122 and/or the backside surface 144. The optical path between the optical pump source 220 and the lasing medium 110 extends through the first heat spreader 120. Here, the lasing medium 110 is sandwiched between the first heat spreader 120 and the second heat spreader 150. Making use of a first and a second heat spreader 120, 150 provides a more efficient cooling of the laser arrangement 10. The contact surface 122 is nevertheless provided with the functional optical layer 130 representing or providing a cavity mirror for the vertically-cavity surface-emitting semiconductor laser.

With the example of Fig. 10 it is the second heat spreader 150 that comprises or provides the emission 140 of the laser gain unit 110, which, at least in sections is provided with an anti-reflex coating 142.

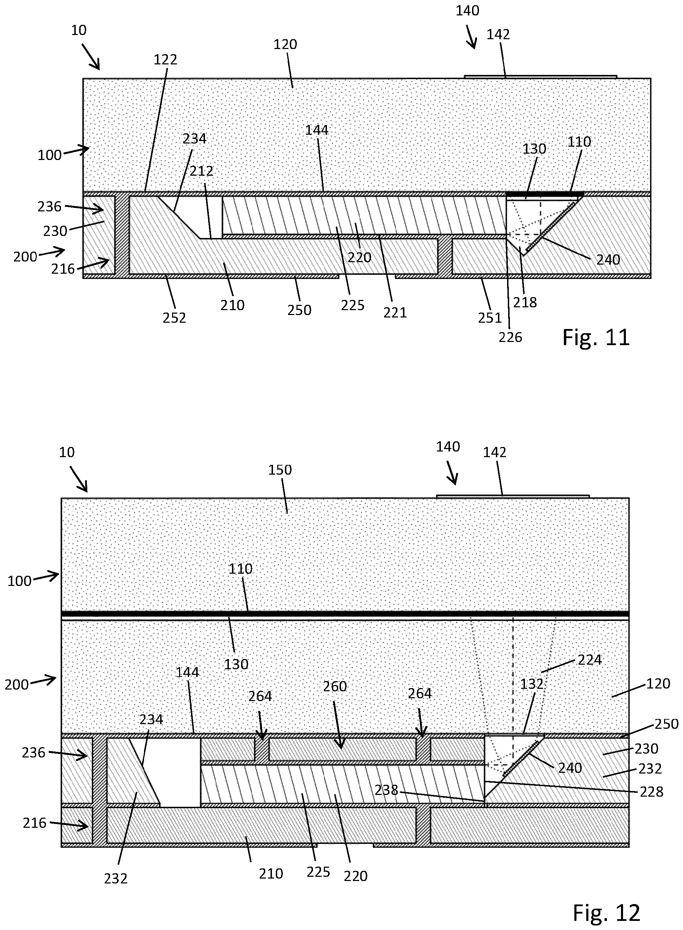

With the further example of Fig. 12 the functional optical layer 130 is shifted into the interface between the first and the second heat spreaders 120, 150. There, a surface of the first heat spreader 120 facing away the optical pump unit 200 is provided with the functional optical layer 130. On top of the functional optical layer 130 there is provided a layer of the lasing medium 110, which in turn is covered by the second heat spreader 150. Here, the first heat spreader 120 is located outside the vertical laser cavity of the laser gain unit 100. With the example of Fig. 12, the backside surface 144 is at least in sections provided or coated with another functional optical layer 132, that serves as an anti-reflex coating for the pump radiation. At least a portion or section of the backside surface 144 that is exposed to the pump radiation 224 is provided with the further functional optical layer 132. An anti-reflex coating as provided by the further functional optical layer 132 helps to avoid reflections at the backside surface 144 and may therefore increase the portion of the pump radiation 224 that reaches the lasing medium 110.

With the example of Fig. 11 the base substrate 210 comprises a recess 218 adjoining the edge-emitting facet 226 of the optical pump source 220. The recess 218 is provided in the bottom surface 212 and may comprise a V-shaped groove in the bottom surface 212. Here, the p-n junction of the semiconducting pump laser 225 may be arranged close or adjacent to the bottom surface 212. In order to enable an unhindered beam propagation and in order to provide a well-defined optical path length to the lasing medium 110 at least a portion of the mirror 240 reaches into this the shaped recess 218. One side of the recess 280 may be provided with the mirror 240. The opposite side of the e.g. V-shaped recess 218 adjoins the edge of the semiconductor pump laser 225.

The recess 218 allows an arrangement of the optical pump source 220 with the p-n junction of the respective pump laser 225 directly adjacent to the base substrate 210 and hence adjacent to the bottom surface 212. Here, a hard solder may be used for providing an electrical contact as well as for providing a mechanical fastening for the optical pump source 220.

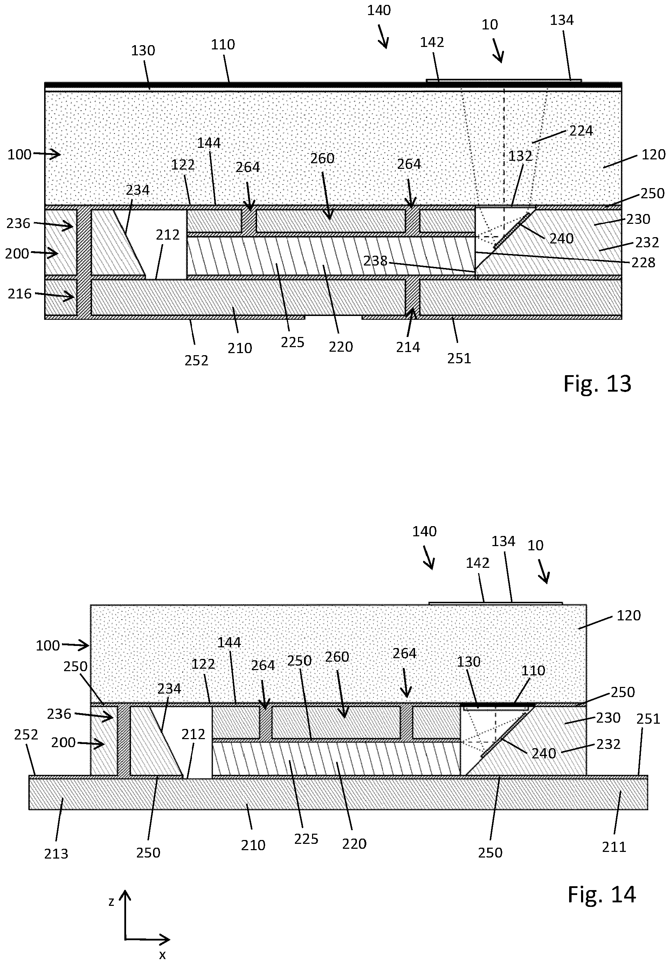

With another example as illustrated in Fig. 13 the laser gain unit 100 comprises only one heat spreader 120. Here, the contact surface 122 of the first heat spreader 120 is mechanically connected to the spacer 230 and/or to the submount 260. Here and in contrast to the example of Fig. 1 the lasing medium 110 as well as the functional optical layer 130 are provided on a side of the first heat spreader 120 that faces away the contact surface 122 or backside surface 144 and hence faces away the optical pump unit 200. Also here, the backside surface 144 is at least in sections provided or coated with another functional optical layer 132, that serves as an anti-reflex coating for the pump radiation and thus aims to increase the portion of pump radiation 224 reaching the lasing medium 110.

As illustrated, the upper side, i.e. that side of the first heat spreader 120 that faces away the optical pump unit 200 is covered or provided with the functional optical layer 130. At least a portion of the dielectric layer 130 or the entire functional optical layer is further covered or coated by the lasing medium 110. At least a portion of the lasing medium 110 may be further covered by the anti-reflex coating 142 or by another functional optical layer 134. This functional optical layer 134 may be highly reflective or partially reflective for the laser radiation 114 and may thus serve as a cavity mirror for the laser cavity, which extends between the bottom functional optical layer 130 and the upper functional optical layer 134. Here, the effective length of the laser cavity is defined by the thickness of the semiconductor lasing medium 110.

With other examples, the laser cavity may be confined by the bottom functional optical layer 130 and by an external mirror 112. Then, the upper functional layer 134 will be replaced by the anti-reflex coating 142.

Generally, and with many examples in which the laser gain unit 110 is provided with an external mirror 112 the emitting surface 140 will be provided with an anti-reflex coating 142 to avoid a sub-cavity effect or etalon effect. Then, the emitting surface 140 may be void of the functional optical layer 134. With other examples, and when the laser gain unit 110 and hence the entire laser arrangement 100 is void of an external mirror 112, the emitting surface 140 may be provided with another functional optical layer 134, that provides a high degree of reflectivity for the laser radiation 224. Here, the functional optical layer 134 may serve as a cavity mirror and the emitting surface 140 may be void of an anti-reflex coating 142.

In Fig. 14 a further example of a laser arrangement 10 is illustrated. There and in contrast to e.g. the examples as illustrated in Figs. 1 or 7 the base substrate 210 comprises a first lateral extension 211 and a second lateral extension 213. The lateral extension 211, 213 protrude laterally from the spacer 230. As illustrated the upper sides of the lateral extensions 211, 213, hence the lateral extension of the bottom surface 212 is/are provided with an electrically conductive structure 250. As an example, the upper side of the first extension 211 is provided, covered or coated with the first electrical contact path 251. The first electrical contact path 251 extends into a middle section of the base substrate 210 located between the first and second oppositely located extensions 211, 213. There, the first electrical contact path 251 is in electrical contact with the optical pump source 220.

The second lateral extension 213 of the base substrate protrudes laterally outwardly from the spacer 230. Its upper side is also provided, covered or coated with an electrically conductive structure 250. It is provided, covered or coated with the second electrical contact path 252. As illustrated, the second electrical contact path 252 extends through the through opening 236, alternatively over the sidewall 234 of the spacer 230 and further extends onto the contact surface 122 of the first heat spreader 120. From there, it is in electrical contact with the conductive structure 250 extending into and through the openings 264 of the submount 260.

The first and second lateral extensions 211, 213 of the base substrate 210 allow for a rather easy and straightforward electrical contact of the optical pump source 220. Here, manufacturing of through openings through the base substrate 210 can be effectively avoided.

### Reference Numerals

- 10: laser arrangement
- 100: laser gain unit
- 110: lasing medium
- 112: external mirror
- 114: laser radiation
- 120: heat spreader
- 122: contact surface
- 130: functional optical layer
- 132: functional optical layer
- 134: functional optical layer
- 140: emitting surface
- 142: anti-reflex coating
- 144: backside surface
- 150: heat spreader
- 200: optical pump unit
- 210: base substrate
- 211: extension
- 212: bottom surface
- 213: extension
- 214: through opening
- 216: through opening
- 218: recess
- 220: optical pump source
- 221: contact side
- 222: contact side
- 224: pump radiation
- 225: pump laser
- 228: counter stop face
- 230: spacer
- 231: contact face
- 232: semiconductor material
- 234: sidewall
- 236: through opening
- 238: stop face
- 240: mirror
- 242: mirror layer
- 250: conductive structure
- 251: electrical contact path
- 252: electrical contact path
- 254: conductor
- 255: conductor
- 256: wire bond
- 260: submount
- 261: first side
- 262: second side
- 263: layer
- 264: through opening
- 270: optical power control
- 272: temperature control
- 280: depression

## Claims

1. An optically pumped semiconductor laser arrangement (10), comprising a laser gain unit (100) and an optical pump unit (200),
the laser gain unit (100) comprising:
- a planar-shaped semiconductor lasing medium (110) operable for vertical surface emission of a laser radiation (114),
- an emitting surface (140) for emission of the laser radiation (114),
- a first heat spreader (120) thermally coupled to the planar-shaped semiconductor lasing medium (110), and
- a backside surface (144) opposite to the emitting surface (140),
the optical pump unit (200) comprising:
- a base substrate (210) comprising a bottom surface (212),
- an optical pump source (220) operable to generate an optical pump radiation (224) and arranged on the base substrate (210), and
- a spacer (230) connected to the base substrate (210) or integrated into the base substrate (210),
- wherein the optical pump unit (200) is mechanically attached to the laser gain unit (100) through a mechanical fastening to the backside surface (144) of the laser gain unit (100).

2. The laser arrangement (10) according to claim 1, wherein at least one of the spacer (230) and the optical pump source (220) are mechanically fastened to the backside surface (144) of the laser gain unit (100).

3. The laser arrangement (10) according to any one of the preceding claims, further comprising a submount (260) comprising a first side (261) mechanically connected to the optical pump source (220) and comprising a second side (262) opposite to the first side (261) and mechanically connected to one of the bottom surface (212) and the backside surface (144) of the laser gain unit (100).

4. The laser arrangement (10) according to any one of the preceding claims, wherein the optical pump source (220) comprises an edge-emitting pump laser (225) effective to deliver optical energy into the lasing medium (110) effective to create a population inversion in the planar-shaped semiconductor lasing medium (110).

5. The laser arrangement (10) according to any one of the preceding claims, wherein the spacer (230) comprises a slanted mirror (240) to deflect or redirect the optical pump radiation (224) towards and into the planar-shaped semiconductor lasing medium (110).

6. The laser arrangement (10) according to claim 5, wherein the optical pump source (220) is oriented to emit the optical pump radiation (224) in a horizontal direction towards the slanted mirror (240) and wherein a horizontal distance between the optical pump source (220) and the slanted mirror (240) is adjusted or is adjustable to realize a predetermined optical path length between the optical pump source (220) and the planar-shaped semiconductor lasing medium (110).

7. The laser arrangement (10) according to any one of the preceding claims, wherein the spacer (230) comprises a crystalline or semicrystalline semiconductor material (232) with a slanted sidewall (234) facing towards the optical pump source (220) and etched anisotropically along a crystallographic plane of the semiconductor material (232).

8. The laser arrangement (10) according to claim 7, wherein at least a portion of the slanted sidewall (234) is coated with a mirror layer (242).

9. The laser arrangement (10) according to any one of the preceding claims, wherein the spacer (230) comprises a stop face (238) to abut with a counter stop face (228) of at least one of the optical pump source (220) and the submount (260).

10. The laser arrangement (10) according to any one of the preceding claims, wherein at least a portion of at least one of the bottom surface (212), the spacer (230) and the submount (260) is coated or covered with an electrically conductive layer (250).

11. The laser arrangement (10) according to any one of the preceding claims, further comprising a first electrical contact path (251) extending through a first through opening (214) of the base substrate (210) or extending on a first lateral extension (211) of the base substrate (210) and being electrically connected to a first contact side (221) of the optical pump source (220).

12. The laser arrangement (10) according to any one of the preceding claims, further comprising a second electrical contact path (252) extending through a second through opening (216) of the base substrate (210) or extending on a second lateral extension (213) of the base substrate (201), the second electrical contact path (252) further extending through or on the spacer (230) and being electrically connected to a second contact side (222) of the optical pump source (220).

13. The laser arrangement according to claim 12, wherein the second electrical contact path (252) is electrically connected to the second contact side (222) via the backside surface (144).

14. The laser arrangement (10) according to any one of the preceding claims, wherein the optical pump unit (200) is mechanically fastened to the backside surface (144) of the laser gain unit (100) by one of soldering or bonding.

15. The laser arrangement (10) according to any one of the preceding claims, wherein the laser gain unit (100) comprises a functional optical layer (130) arranged in an optical path of the optical pump radiation (224) between the planar-shaped semiconductor lasing medium (110) and the optical pump source (220), wherein the functional optical layer (130) is substantially reflective for the laser radiation (114) and is substantially transmissive for the optical pump radiation (224).
